(19) **Europäisches Patentamt / European Patent Office / Office européen des brevets**

(11) **EP 4 756 808 A1**

(12) **EUROPEAN PATENT APPLICATION**

(43) Date of publication:
**10.06.2026 Bulletin 2026/24**

(21) Application number: **25217933.8**

(22) Date of filing: **24.11.2025**

(51) International Patent Classification (IPC):
*G11C 13/00* (2006.01)

(52) Cooperative Patent Classification (CPC):
**G11C 13/0004; G11C 13/0061; G11C 13/0069;**
G11C 2013/0078; G11C 2013/0088;
G11C 2013/0092

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **04.12.2024 IT 202400027417**

(71) Applicant: **STMicroelectronics International N.V.
1228 Plan-les-Ouates, Geneva (CH)**

(72) Inventors:
• **TOMAIUOLO, Francesco
 I-95024 Acireale (Catania) (IT)**

• **BUONO, Luigi**
 **I-95030 Gravina di Catania (Catania) (IT)**
• **RUTA, Marco**
 **I-95027 San Gregorio di Catania (Catania) (IT)**
• **DE COSTANTINI, Diego**
 **I-96011 Augusta (Siracusa) (IT)**
• **GIBILARO, Marco Eugenio**
 **I-95021 Aci Castello (Catania) (IT)**
• **LAURICELLA, Marco Maria**
 **I-95030 Mascalucia (Catania) (IT)**

(74) Representative: **Buzzi, Notaro & Antonielli d'Oulx
S.p.A.
Corso Vittorio Emanuele II, 6
10123 Torino (IT)**

(54) **METHOD OF PERFORMING PROGRAM OPERATIONS IN PHASE CHANGE MEMORIES, CORRESPONDING DEVICE AND COMPUTER PROGRAM PRODUCT**

(57)    A method of performing write operations in a Phase Change Memory, PCM, device, the PCM device comprising a current pulse source configured to generate a highest level of source current and to produce current pulses out of set current pulses ($PS_a$; $PS_b$) and reset current pulses ($PR_a$; $PR_b$), and a plurality of cells arranged in a plurality of groups ($100_a$; $100_b$), wherein groups in the plurality of groups ($100_a$; $100_b$) comprise respective sets of cells configured to be written via respective write operations.

The method comprises performing the write operations via set current pulses ($PS_a$; $PS_b$) for each set of cells comprising at least one cell to be written via a set write operation, and via reset current pulses ($PR_a$; $PR_b$) for each set of cells comprising at least one cell to be written via a reset write operation.

The set current pulses ($PS_a$; $PS_b$) provided to cells comprised in one group of the plurality of groups ($100_a$; $100_b$) are time-shifted with respect to set current pulses ($PS_a$; $PS_b$) provided to cells comprised in the other groups, and the reset current pulses ($PR_a$; $PR_b$) provided to cells comprised in one group of the plurality of groups ($100_a$; $100_b$) are dis-overlapped with respect to reset current pulses ($PR_a$; $PR_b$) provided to cells comprised in the other groups.

A sum of the set current pulses ($PS_a$; $PS_b$) and the reset current pulses ($PR_a$; $PR_b$) provided to cells comprised in the plurality of groups ($100_a$; $100_b$) at a common write time is equal to or lower than the highest level of source current of the current pulse source.

FIG. 4

**Description**

Technical field

The description relates to data storage technologies.

One or more embodiments can be applied to computer storage technologies such as non-volatile memories NVM, for instance, PCM, that is, Phase Change Memory such as ePCM (that is, embedded Phase Change Memory) and/or ePCM NVM (that is, Non-Volatile Memory ePCM).

Background

Phase Change Memories, referred to as PCM, are a type of computer storage technology, that is, memory technology and, generally, a type of non-volatile random-access memory technology that can be embedded in integrated circuit (IC) semiconductor devices.

Usually, PCM operates on a bit-by-bit basis since the heat produced by an electric current flowing through a heating material called phase-change material, for instance, a chalcogenide glass such as GST ("Germanium-Antimony-Tellurium"), is used to melt and quench the phase-change material, making it amorphous, or to hold such phase-change material in its crystallization temperature range, thereby switching it to a crystalline state.

Therefore, a PCM storage unit may use such phase-change material to store 1-bit of information since the two states of the phase-change material, that is, amorphous or crystalline, are characterized by different resistance values that facilitate distinguishing one of the states from the other, that is, each of the two states corresponds to a different value of a single bit.

Thus, the phase-change material can stably exist in two states:

an amorphous or disordered state, characterized by high electrical resistivity, that is, by high resistance, for instance, about 0.6 MΩ, representing, for instance, a low logical state, for instance, '0', characterized by a low current flowing through it, or
a crystalline or ordered state, characterized by low electrical resistivity, that is, by low resistance, for example, a resistance lower than that of the amorphous state, for instance, about 18 kΩ, representing, for instance, a high logical state, for instance, '1', characterized by a high current flowing through it.

A PCM storage unit can switch between such two states by differently heating the phase-change material, that is, by applying a current to such phase-change material for a given time for switching to a first state and by applying a current of different value to such phase-change material for a different time for switching to a second state.

For instance, a "set" write operation of a specific cell, that is, setting the cell to a high logic level, may be performed by applying on the phase-change material of such specific cell a current (for instance, a current pulse with triangular shape) that heats the respective phase-change material above a crystallization temperature associated to such respective phase-change material, but under a melt temperature associated with the same phase-change material, for a given time.

For instance, a "reset" write operation of a specific cell, that is, setting the cell to a low logic level, can be performed by applying on the phase-change material of such specific cell a current (for instance, a short rectangular current pulse) that heats the respective phase-change material above the melt temperature associated with such respective phase-change material for a given time, for instance, shorter than the one considered in a "set" write operation.

For instance, a read operation of a specific cell may be done by testing the resistance value, for instance, through a current pulse, of the phase-change material of the specific cell in order to detect the current phase, that is, amorphous or crystalline, of the phase-change material.

It is noted that "set" write operations and "reset" write operations may be collectively referred to as write operations in the following description, therefore, a write operation performed on a given cell may be either a set write operation, that is, to set such given cell to a high logic level, or a reset write operation, that is, to set such given cell to a low logic level.

It is also noted that the set write operations and the reset write operations can be considered as operations used for programming the PCM, that is, program operations, since such operations allow to change the state of the bits comprised in the PCM.

A single-ended PCM is /a type of PCM wherein a single cell corresponds to a single bit (that is, 1 cell/bit).

Therefore, in single-ended PCM each bit is associated to a respective cell. Such respective cell may be either in a SET state, that is, in a crystalline state having a low resistance that is usually associated to a high logic level bit (a bit having a bit state equal to "1"), or in a RESET state, that is, in an amorphous state having a high resistance that is usually associated to a low logic level bit (a bit having a bit state equal to "0").

Each time the state of a bit changes, for instance, in response to a program operation, the state of the respective cell changes.

For example, if the bit changes from a low logic level, that is, from "0", to a high logic level, that is, to "1", the state of the respective cell changes from an amorphous state, that is, from a RESET state, to a crystalline state, that is, to a SET state.

Similarly, if the bit changes from a high logic level, that is, from "1", to a low logic level, that is, to "0", the state of the respective cell changes from a crystalline state, that is, from a SET state, to an amorphous state, that is, to a RESET state.

Read operations in single-ended PCM are performed by using a reference current supplied, for instance, by a reference current generator, and a sense amplifier receiving:

  at one terminal, a current from a PCM cell that is to be read, and
  at the other terminal, a reference current supplied by the reference-current generator.

Document US 2009/0161417 A1 discloses two-cells-per-bit PCM architecture (that is, 2 cell/bit), that is, PCM architecture wherein two cells contain a single bit of data and one of the two cells, a complementary cell, is programmed to the complementary state of the other of the two cells. Thus, a bit is determined by reading a bit stored in one of the two cells and comparing it to the one stored in the complementary cell, thus, performing a differential reading operation.

A differential reading operation considers both the stored value of such data in a cell in its direct form, that is, high or low logic level respectively, and the stored value of such data in a complementary cell in its complemented form, that is, low or high logic level respectively.

Hence, the result of the differential reading operation is obtained through the use of a sense amplifier that is configured to receive at one terminal, for instance, on a first side, for instance, a left side, or on a second side, for instance, a right side, a current of the "direct" cell that has to be read, that is, containing the data in the direct form, and at the other terminal, for instance, on the second side or on the first side respectively, a current of the associated complementary cell, that is, containing the data in the complemented form.

Thus, the "direct" cell and the complementary cell are configured to be in opposite states. For instance, if one of the two cells, for instance, the direct cell, is in a SET state (characterized by low resistance and high current), the complementary cell is in a RESET state (characterized by high resistance and low current), or vice versa.

Therefore, the sense amplifier is configured to compare the current received from the direct cell and the current received from the associated complementary cell, and:

  if the current received from the direct cell is higher than the current received from the associated complementary cell, the sense amplifier is configured to read a logic level equal to 1 ("one"), that is, a high logic level, and
  if the current received from the direct cell is lower than the current received from the associated complementary cell, the sense amplifier is configured to read a logic level equal to 0 ("zero"), that is, a low logic level.

As a result, a reading operation of a bit in a two-cells-per-bit PCM may be more reliable than reading operations of bits in single-ended PCMs, as a read window in two-cells-per-bit PCMs is twice as wide as that used in single-ended PCMs.

The read window in two-cells-per-bit PCMs depends on a difference between a current flowing in a direct cell and a current flowing in an associated complementary cell, which corresponds to a difference between a current flowing within a cell set to a high logic level, that is, a current flowing in a direct or in a complementary cell, and a current flowing in a cell set to a low logic level, that is, a current flowing in a complementary or in a direct cell respectively.

Conversely, the read window in single-ended PCMs depends on a difference between a current flowing in a cell, that is, a current flowing within a cell set to a high or a low logic level, and a reference current, such reference current being midway between a current flowing within a cell set to a high logic level and a cell set to a low logic level.

Hence, two-cells-per-bit PCM architectures improve the reliability of read operations as a reference current is not needed since read operations are based on differential readings and as the two-cells-per-bit read window is doubled.

In addition, two-cells-per-bit PCM architectures may usually provide higher robustness, reliability, and retention at hot than single-ended PCM architectures as two-cells-per-bit PCMs are characterized by:

  redundancy of information, that is, a single bit is stored in two cells instead of a single one, and
  the possibility of implementing a differential reading strategy, that is, allowing the reading of the content of cells without using a reference current.

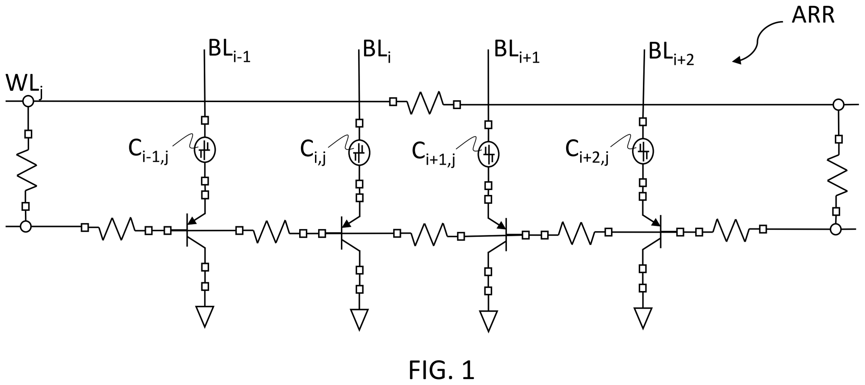

Figure 1 illustrates a conventional structure of a PCM array ARR.

A PCM array ARR may comprise one or more sets of cells, for instance, comprising cells $C_{i-1,j}$, $C_{i,j}$, $C_{i+1,j}$, and $C_{i+2,j}$ of Figure 1, that are collectively referred to with the reference C, coupled together.

It is noted that the resistances of Figure 1 are not physical elements but arise from parasitic connections.

It is noted that such one or more sets of cells C may be comprised in different subset of the array, for instance, either in a first subset of the PCM array ARR, for instance, a subset of the PCM array comprising cells that are coupled to a first side of a sense amplifier, for instance, a left side, or in a second subset of such PCM array ARR, for instance, a subset of the PCM array comprising cells that are coupled to a second side of such sense amplifier, for instance, a right side.

It is noted that, if a direct cell is comprised in the first subset of the PCM array ARR, the respective complementary cell is comprised in the second subset of the PCM array ARR, and vice versa.

The one or more sets of cells comprised in the PCM array are arranged in word lines WL, that are, the rows of the array, and bit lines BL, that are, the columns of the array.

Each cell in the plurality of cells C is coupled to a respective bit line BL and to a respective word line WL, for instance, through a bipolar transistor acting as selector.

Each cell in the plurality of cells C is coupled to a different pair of lines comprising a bit line BL and a word line WL, so that the respective bit line BL and the respective word line WL to which a given cell is coupled can be considered as providing coordinates to unambiguously identify such given cell.

For instance, the set of cells C illustrated in Figure 1 is comprised in a word line $WL_j$ and each of such cells C is further coupled with a respective bit line, for instance, to a bit line $BL_{i-1}$, $BL_i$, $BL_{i+1}$, or $BL_{i+2}$ of Figure 1, that are collectively referred to with the reference BL.

It is noted that the cells C of the PCM array ARR may also be organized in tiles, such tiles being memory sub-blocks (that is, array sub-blocks) comprising cells that are arranged in bit lines BL and word lines WL, each of such tiles being accessible and operable independently.

It is noted that each time a state of a bit is changed, for instance, in response to the performing of a program operation, respective states of two cells comprising such bit (either in the direct or in the complemented form) are changed accordingly, that is, the state of the direct cell containing the bit in the direct form and the state of the complementary cell comprising the bit in the complemented form are both changed.

For instance, a cell (the direct cell or the complementary cell) that is in a RESET state before the performing of the program operation changes its state to a SET state, while the other cell (the complementary cell or the direct cell, respectively) that is in a SET state before the performing of the program operation changes its state to a RESET state.

Therefore, only a cell in a couple of cells storing a same bit, such couple of cells comprising a direct cell and the respective complementary cell, is in a SET state and only a cell in such couple of cells storing the same bit is in a RESET state.

It is noted that, during the performing of such program operation, a first current is injected in the direct cell that is to be programmed, that is, the direct cell containing the bit in the direct form that change its state, and a second current is injected in the complementary cell that is to be programmed, that is, the complementary cell containing the bit in a complemented form that change its state, such current being injected in such cells through respective bit lines BL coupled thereto.

In known solutions, PCMs are configured to perform program operations on one or more direct cells or in one or more complementary cells in parallel.

The number of cells that can be programmed at the same time, receiving at the same time a set current pulse (used to perform a set write operation) or a reset current pulse (used to perform a reset write operation), is limited by the drive capability of a program pump configured to generate the current that is to be injected in the cells in order to perform program operations.

Therefore, in order to speed up the program time of the PCM, it would be advantageous to maximize the number of cells that can be programmed at the same time by such program pump.

Hence, solutions that can reduce the time required for programming the PCM by maximizing the number of cells that can be programmed at the same time by the program pump would be advantageous.

Object and summary

An object of one or more embodiments is to contribute in providing solutions that can reduce the time required for programming the PCM, maximizing the number of cells that can be programmed at the same time via a program pump, in order to speed up the program time of the PCM.

According to one or more embodiments, that object is achieved via a method of performing program operations in phase change memories having the features set forth in the claims that follow.

One or more embodiments concern a corresponding memory device and a corresponding computer program product loadable in at least one processing circuit (for instance, a computer) and comprising software code portions for executing the steps of the method when the product is run on at least one processing circuit.

As used herein, reference to such a computer program product is understood as being equivalent to reference to a computer-readable medium containing instructions for controlling a processing system in order to co-ordinate implementation of the method according to one or more embodiments.

The claims are an integral part of the technical teaching provided in respect of the embodiments.

Solutions as described herein include a method of performing program operations, that is, write operations, in a Phase Change Memory ("PCM") device.

PCM devices according to solutions as described herein comprise:

a current pulse source, for instance, a current ("program") pump, configured to generate a highest level of source current and to produce current pulses out of set current pulses and reset current pulses; and a plurality of cells arranged in a plurality of groups, wherein groups in said plurality of groups comprise respective sets of cells configured to be written via respective write operations.

The method according to solutions as described herein comprise performing said write operations:

via set current pulses for each set of cells comprising at least one cell to be written via a set write operation, and via reset current pulses for each set of cells comprising at least one cell to be written via a reset write operation.

It is noted that, in solutions as described herein, set current pulses provided to cells comprised in one group of the plurality of groups are time-shifted with respect to set current pulses provided to cells comprised in the other groups of the plurality of groups.

In addition, reset current pulses provided to cells comprised in one group of the plurality of groups are dis-overlapped with respect to reset current pulses provided to cells comprised in the other groups of the plurality of groups.

In solutions as described herein, a sum of the set current pulses and the reset current pulses provided to cells comprised in the plurality of groups at a common write time is equal to or lower than said highest level of source current of the current pulse source.

In addition, solutions as described herein may comprise performing said respective write operations targeting a maximum number of cells written via respective set or reset write operations at said common write time.

Therefore, solutions as described herein facilitate reducing a time required for programming the PCM, accelerating such PCM program time.

Brief description of the figures

One or more embodiments will now be described, by way of example only, with reference to the annexed figures, wherein:

Figure 1 is a conventional structure of a PCM array;
Figure 2A and Figure 2B illustrate subsequent reset and set current pulses respectively;
Figures 3A and 3B illustrate conventional sequences of set and reset current pulses, respectively;
Figure 4 illustrates sequences of set and reset current pulses according to embodiments of the present description;
Figure 5 illustrates sequences of set current pulses and a respective parallelism, that is, a respective number of cells that can be written in parallel for each set current pulse, according to embodiments of the present description; and
Figure 6 illustrates a control logic according to embodiments of the present description driving two set of exemplary program divers, for instance, N+1 program drivers, used in program operations of the PCM.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As described in the above, solutions as described herein aim at managing a plurality of program operations (that is, set write operations and/or reset write operations) in a phase change memory at the same time, maximizing the number of cells that can be programmed at the same time via a program pump, in order to reduce a time required for programming the PCM.

It is noted that, even if the following description is mainly focused on PCM NVM structures, same conclusions also apply to computer storage technologies such as PCM, that is, Phase Change Memory, ePCM, that is, embedded Phase Change Memory, and/or ePCM NVM, that is, Non-Volatile Memory ePCM.

Similarly, solutions as described herein may refer to single-ended PCMs, two-cells-per-bit PCMs, or multi-level PCMs.

It is noted that the maximum number of cells that can be programmed at the same time via a program pump may be limited by:

low beta values, for example around 0.45, of the transistors acting as selectors and coupled between the word lines WL and respective cells C, such beta value being a parameter indicating a relationship between an output current, for instance, a collector current, and an input current, for instance, a base current, of such transistors acting as selectors;

IR drops, comprising word line IR drops and bit line IR drops, such IR drops being voltage drops caused by currents flowing through word line and bit line parasitic resistors, for instance, during a program operation performed on a cell; and

a maximum current that can be provided by a program pump, that is, a program pump drive capability, such program pump being configured to generate the current that is to be injected in the cells, for instance for performing the program operations.

In fact, if a program operation is performed on a cell that is to be programmed, such cell being coupled to a respective word line WL via a respective transistor acting as selector, the low beta value of the transistor may lead to most of the current injected in the cell that is to be programmed via such program operation flowing through the control terminal, for instance, the base terminal, of such transistor coupled to the word line WL.

In addition, a (high) IR drop may limit the number of cells comprised in a same tile that can be programmed via program operations at the same time.

Such a limit resulting from the IR drop can arise for the behaviours described in the following.

In fact, it is noted that the IR drop affecting the word lines WL depends on a total current that is injected in such word lines WL during program pulses, such total current being obtained in response to the injection of a current during a program operation of a cell to be programmed (to a SET or RESET state) via the bit line BL coupled to such cell.

Such total current corresponds to the sum of the currents flowing in the cells programmed at the same time and connected to a same word line WL, inside a same tile.

If the IR drop affecting a word line WL increases, the voltage that is to be applied to the corresponding bit lines BL and the voltage provided as output by the program pump are to be increased in response.

It is further noted that, by construction, the current that a generic charge pump can provide decreases, thus, increasing the output voltage of the pump.

Therefore, the higher the number of cells in the same tile that are programmed at the same time:

the higher the IR drop on the corresponding word line WL;
the higher the voltage that is to be applied to the corresponding bit line BL;
the higher the voltage provided as output by the program pump; and
the lower the current that can be provided by the charge pump.

Furthermore, a total number of cells in the PCM, that is, in all the tiles, that can be programmed via program operations at the same time may be limited by such maximum current provided by the program (charge) pump.

In fact, the program pump may be configured to provide the current for programming a certain number of cells at the same time, such current that is provided (at a certain voltage) being limited, therefore, limiting the maximum number of the cells that can be programmed in parallel.

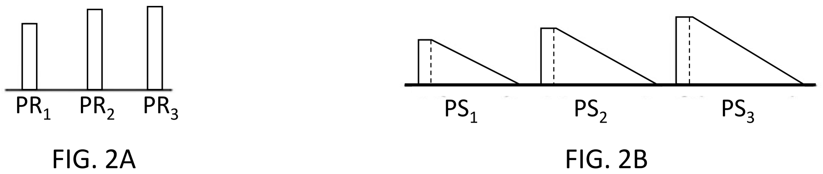

For instance, exemplary reset pulses and exemplary set pulses are illustrated in Figure 2A and Figure 2B respectively.

Figure 2A illustrates a sequence of increasing reset current pulses PR that can be used for reset write operations, including at least:

a first reset pulse PR1, for instance, with a rectangular shape, for instance, with a value that is about 240 $\mu$A and that lasts for about 0.1 $\mu$s, which is used in a first attempt of a reset write operation,
a second reset pulse PR2, for instance, with a rectangular shape, for instance, with a value that is about 270 $\mu$A and that lasts for about 0.1 $\mu$s, which is used in a second attempt of the reset write operation if the previous reset write operation failed, that is, if the first attempt of the reset write operation failed, and
a third reset pulse PR3, for instance, with a rectangular shape, for instance, with a value that is about 300 $\mu$A and that lasts for about 0.1 $\mu$s, which is used in a third attempt of the reset write operation if the previous reset write operation failed, that is, if the second attempt of the reset write operation failed.

It is noted that successive reset pulses have an increasing value, therefore, the value of the third reset pulse PR3 is higher than the values of the second reset pulse PR2 and the first reset pulse PR1, and the value of the second reset pulse PR2 is higher than the value of the first reset pulse PR1.

Figure 2B illustrates a sequence of increasing set current pulses PS that can be used for set write operations, including at least:

a first set pulse PS1, for instance, comprising a first rectangular shape, for instance, with a maximum value that is about 160 $\mu$A which lasts for about 0.2 $\mu$s, and a second triangular shape, for instance, decreasing from the maximum value with a slope of about 0.045 $\mu$A/ns and that lasts for about 3.5 $\mu$s, as illustrated in Figure 2B, which is used in a first attempt of a set write operation,
a second set pulse PS2, for instance, comprising a first rectangular shape, for instance, with a maximum value that is about 230 $\mu$A which lasts for about 0.2 $\mu$s, and a second triangular shape, for instance, decreasing from the maximum value with a slope of about 0.045 $\mu$A/ns and that lasts for about 5 $\mu$s, as illustrated in Figure 2B, which is used in a second attempt of the set write operation if a previous set write operation failed, that is, if the first set write operation failed, and
a third set pulse PS3, for instance, comprising a first rectangular shape, for instance, with a maximum value that is about 260 $\mu$A which lasts for about 0.2 $\mu$s, and a second triangular shape, for instance, decreasing from the maximum value with a slope of about 0.045 $\mu$A/ns and that lasts for about 5.7 $\mu$s, as illustrated in Figure 2B, which is used in a third attempt of the set write operation if a previous set write operation failed, that is, if the second set write operation failed.

It is noted that successive set pulses have an increasing value, therefore, the value of the third set pulse PS3 is higher than the values of the second set pulse PS2 and the first set pulse PS1, and the value of the second set pulse PS2 is higher than the value of the first set pulse PS1.

Therefore, write operations, for instance, either set write operations or reset write operations, performed after a previously failed write operations, for instance, either failed set write operations or failed reset write operations respectively, are performed with current pulses, for instance, set PS or reset PR current pulses respectively, of increased value in order to decrease the probability of a further failed write operation.

It is noted that the reset/set current pulses illustrated in Figures 2A and 2B are shown by way of example only, thus:

a smaller number of current pulses may be considered, for instance, a single or a pair of current pulses, or a higher number of current pulses, for instance, an additional current pulse may be used, for instance, to perform a fourth reset/set write operation if a previous reset/set write operation failed, that is, if the third reset/set write operation failed, different current ($\mu$A) and time ($\mu$s) values may be considered for each of the reset/set current pulses, and/or different shapes may be considered for each of the reset/set current pulses.

It is noted that to enhance the clarity and conciseness of the following description, the shape of the set pulses PS (even if their shape is that illustrated in Figure 2B) are approximated with a triangular shape in order to avoid repeating the description of the shape formed by a first rectangular shape and a second triangular shape.

It is noted that during set current pulses, due to the triangular shape of such set pulses PS, the current that the program pump provides decreases linearly. In fact, the program pump provides a maximum set current only at the beginning of the set current pulses, for instance, for the duration of the rectangular shape (about 0.2 $\mu$s from the beginning of such set current pulses) if the shape of Figure 2B is considered.

During reset current pulses, a time gap (of about 20 to 30 nanoseconds) is present between reset pulses given to different groups of cells, such time gap corresponding to a time required for deselecting a previous group of cells that have been pulsed via previous reset current pulses and for selecting a next group of cells that are to be pulsed via further reset current pulses.

Therefore, since during set current pulses the current provided by the program pump decreases and during reset current pulses the time gap is present, the program pump is underutilized.

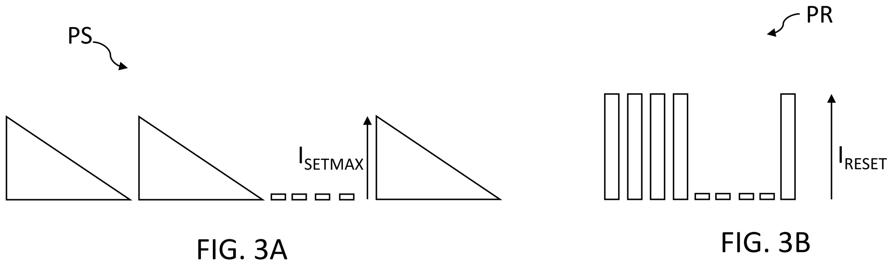

For example, Figures 3A and 3B illustrate conventional sequences of set PS and reset PR current pulses, respectively.

Figure 3A illustrates exemplary set current pulses PS having a triangular shape with a maximum set current $I_{SETMAX}$ provided at the beginning of each of the set current pulses PS.

Figure 3B illustrates exemplary reset current pulses PR having a rectangular shape with a height equal to a reset current $I_{RESET}$.

It is noted that if:

the maximum set current $I_{SETMAX}$ is provided at the beginning of each of the set current pulses PS;
the reset current $I_{RESET}$ is the current of the reset current pulse PR for each cell; and
a maximum pump current $I_{PUMP}$ is the maximum current that can be provided by the program pump;

then, the maximum number of cells that can be programmed in parallel, that is, at the same time, during set write operations and reset write operations are, respectively:

$SETp_{MAX} = I_{PUMP}/I_{SETMAX}$, thus, the maximum number of cells that can be programmed in parallel during a set write operation $SETp_{MAX}$ is obtained by dividing the maximum pump current $I_{PUMP}$ for the maximum set current $I_{SETMAX}$ (and, if the result is not an integer, by rounding down such result); and
$RESETp_{MAX} = I_{PUMP}/I_{RESET}$, thus, the maximum number of cells that can be programmed in parallel during a reset write operation $RESETp_{MAX}$ is obtained by dividing the maximum pump current $I_{PUMP}$ for the reset current $I_{RESET}$ (and, if the result is not an integer, by rounding down such result).

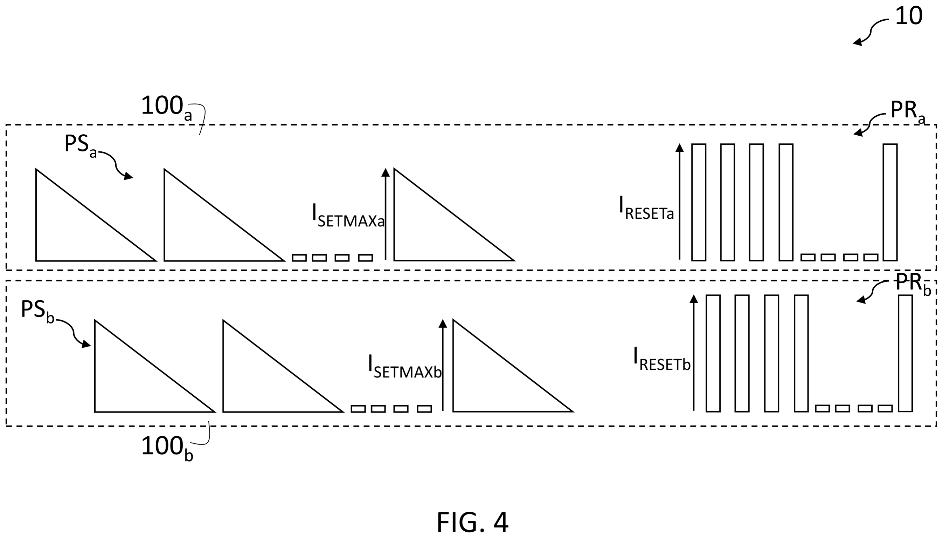

Figure 4 illustrates sequences 10 of set $PS_a$ and $PS_b$ and reset $PR_a$ and $PR_b$ current pulses according to embodiments of the present description.

In solutions according to the present description, the cells C of a PCM device are divided in a plurality of groups, for instance, comprising a first group $100_a$ and a second group $100_b$.

Each group of cells in the plurality of groups can be pulsed independently from the other groups comprised in such plurality of groups.

In addition, each group of cells in the plurality of groups comprises one or more cells that are configured to be written via a respective write operation, for instance, a set write operation or a reset write operation.

Therefore, if a group comprises at least one cell that is to be written via a set write operation, a respective set write operation may be performed on such at least one cell via a respective set current pulse.

Similarly, if a group comprises at least one cell that is to be written via a reset write operation, a respective reset write operation may be performed on such at least one cell via a respective reset current pulse.

In case of set current pulses, the pulses given to each group of cells in the plurality of groups are time-shifted with respect to the ones given to the other groups comprised in such plurality of groups.

In case of reset current pulses, the pulses given to each group of cells in the plurality of groups are dis-overlapped with respect to the ones given to the other groups comprised in such plurality of groups.

It is noted that even if the following description mainly considers a plurality of groups of cells comprising a first group of cells and a second group of cells, more than two groups of cells can also be considered.

In such a case, that is, if more than two groups of cells are considered, each group of cells can be pulsed independently and, for instance:

in case of set current pulses, the pulses given to a second group comprised in the plurality of groups of cells are shifted with respect to the ones given to a first group comprised in such plurality of groups of cells, the pulses given to a third group comprised in such plurality of groups of cells are shifted with respect to the ones given to such second group, and pulses given to further groups (if present) comprised in such plurality of groups of cells are shifted with respect to the ones given to a previous group of cells; and
in case of reset current pulses, the pulses given to each group in the plurality of groups of cells are dis-overlapped with respect to the ones given to each other group in the plurality of groups of cells.

Therefore, considering for each time instant the sum of the currents provided to all the groups in the plurality of groups of cells, such sum is to be equal or smaller than the maximum current that can be provided by the program pump.

Therefore, solutions as described herein refers to a method of performing write operations, that is, program operations comprising set write operations and/or reset write operations, in a Phase Change Memory, PCM, device.

Such PCM device comprises:

a current pulse source, for instance, a program pump (preferably a current pump), configured to generate a highest level of source current, that is, a maximum current that can be provided by such current pulse source, and to produce current pulses out of set current pulses and reset current pulses; and

a plurality of cells C arranged in a plurality of groups, wherein groups in such plurality of groups comprise respective sets of cells configured to be written via respective write operations.

The method described herein comprises performing such write operations:

via set current pulses for each set of cells comprising at least one cell to be written via a set write operation; and

via reset current pulses for each set of cells comprising at least one cell to be written via a reset write operation.

It is noted that, as previously described, set current pulses provided to cells comprised in one group of the plurality of groups are time-shifted with respect to set current pulses provided to cells comprised in the other groups of the plurality of groups.

Again, as previously described, reset current pulses provided to cells comprised in one group of the plurality of groups are dis-overlapped with respect to reset current pulses provided to cells comprised in the other groups of the plurality of groups.

It is noted that a sum of the set current pulses and the reset current pulses provided to cells comprised in the plurality of groups, that is, to the plurality of cells C, at a common write time, that is, at a same time, is equal to or lower than such highest level of source current of the current pulse source.

It is noted that such method may also comprise performing such respective write operations, that is, set or reset write operations, targeting a maximum number of cells written via respective set or reset write operations at such common write time, that is, maximizing the number of cells programmed at a same time.

Figure 4 illustrates a scenario where the plurality of groups comprises two groups, a first group $100_a$ and a second group $100_b$.

For instance, in the exemplary scenario of Figure 4, both the first group $100_a$ and a second group $100_b$ comprise one or more cells that are configured to be written via a respective write operation, for instance, both via set write operations and reset write operations.

Therefore, to perform such set write operations, the first group of cells $100_a$ may be pulsed via first set current pulses $PS_a$ having a triangular shape with a first maximum set current $I_{SETMAXa}$ provided at the beginning of each of the first set current pulses $PS_a$.

Similarly, to perform reset write operations, such first group of cells $100_a$ may be pulsed via first reset current pulses $PR_a$ having a rectangular shape with a height equal to a first reset current $I_{RESETa}$.

The second group of cells $100_b$ may be pulsed via second set current pulses $PS_b$ having a triangular shape with a second maximum set current $I_{SETMAXb}$, for instance, equal to the first maximum set current $I_{SETMAXa}$, provided at the beginning of each of the second set current pulses $PS_b$.

Similarly, such second group of cells $100_b$ may be pulsed via second reset current pulses $PR_b$ having a rectangular shape with a height equal to a second reset current $I_{RESETb}$, for instance, equal to the first reset current $I_{RESETa}$.

Therefore, in the method according to solutions as described herein, such plurality of cells C may be arranged in two groups:

a first group of cells, for instance, the first group of cells $100_a$, comprising a first set of cells configured to be written via respective write operations, and

a second group of cells, for instance, the second group of cells $100_b$, comprising a second set of cells configured to be written via respective write operations.

In the scenario illustrated in Figure 4, in case of set current pulses, the pulses given to the second group of cells $100_b$ may be time-shifted with respect to the ones given to the first group of cells $100_a$, and in case of reset current pulses, the pulses given to such second group of cells $100_b$ may be dis-overlapped with respect to the ones given the first group of cells $100_a$.

In case of reset current pulses, shifting the reset current pulses in order to obtain a first sequence of reset current pulses $PR_a$ provided to cells comprised in the first group of cells $100_a$ and a second sequence of reset current pulses $PR_b$ provided to cells comprised in the second group of cells $100_b$ comprising dis-overlapped reset current pulses may allow to completely recover the time gap, usually of about 20 to 30 nanoseconds, that was lost in sequences according to Figure 3B.

In this regard, both the first sequence of reset current pulses $PR_a$ provided to cells comprised in the first group of cells $100_a$ and the second sequence of reset current pulses $PR_b$ provided to cells comprised in the second group of cells $100_b$ comprise respective time gaps (of about 100 nanoseconds, that is, the duration of a reset current pulse) as the time required for deselecting a previous group of cells that have been pulsed via previous reset current pulses and for selecting a next group of cells that are to be pulsed via further reset current pulses is still required.

During a time gap of one of the sequences, such time gap having a duration equal to the duration of a reset current pulse, a reset current pulse can be provided by the other sequence in order to remove time gaps from a combination of the first sequence of reset current pulses $PR_a$ and the second sequence of reset current pulses $PR_b$, thus, recovering the time gaps form such combination of the first sequence of reset current pulses $PR_a$ and the second sequence of reset current pulses $PR_b$.

Therefore, in methods according to solutions as described herein, reset current pulses $PR_a$ provided to the first set of cells, that is, to the cells that are to be written comprised in the first group of cells $100_a$, are dis-overlapped with respect to reset current pulses $PR_b$ provided to the second set of cells, that is, to the cells that are to be written comprised in the second group of cells $100_b$.

As described above, such reset current pulses $PR_a$ provided to the first set of cells may be comprised in a first sequence of reset current pulses and such reset current pulses $PR_b$ provided to the second set of cells may be comprised in a second sequence of reset current pulses.

In such a case, the reset current pulses $PR_b$ comprised in the second sequence of reset current pulses can be provided in correspondence of gaps, that is, time gaps, of the first sequence of reset current pulses.

Similarly, the reset current pulses $PR_a$ comprised in the first sequence of reset current pulses can be provided in correspondence of gaps, that is, time gaps, of the second sequence of reset current pulses.

It is noted that a reset current pulse $PR_a$ comprised in the first sequence of reset current pulses can be provided, at a first common write time (that is, in correspondence of a first time instant), to a number of cells of the first set of cells (that is, to a number of cells that are to be written comprised in the first group of cells $100_a$) targeting a maximum number of cells written in a respective reset write operation performed via said reset current pulse $PR_a$ (comprised in the first sequence of reset current pulses) at said first common write time, that is, via the reset write operation performed by providing said reset current pulse $PR_a$ to such cells that are to be written comprised in the first group of cells $100_a$ in correspondence of such first time instant.

Similarly, a reset current pulse $PR_b$ comprised in said second sequence of reset current pulses can be provided, at a second common write time (that is, in correspondence of a second time instant), to a number of cells of the second set of cells (that is, to a number of cells that are to be written comprised in the second group of cells $100_b$) targeting a maximum number of cells written in a respective reset write operation performed via said reset current pulse $PR_b$ (comprised in said second sequence of reset current pulses) at said second common write time, that is, via the reset write operation performed by providing said reset current pulse $PR_b$ to such cells that are to be written comprised in the second group of cells $100_b$ in correspondence of such second time instant.

Therefore, solutions as described herein aim at maximizing the number of cells that can be written via each reset write operation performed either in the first group of cells $100_a$ or in the second group of cells $100_b$.

Such maximum number of cells written in a respective reset write operation performed via a reset current pulse $PR_a$ or $PR_b$ at a common write time (the first or the second common write time respectively) may be obtained by dividing the highest level of source current of the current pulse source, for instance, the maximum pump current $I_{PUMP}$ that can be provided by the program pump, by a highest current of the reset current pulse, for instance, the reset current $I_{RESET}$ ($I_{RESETa}$ or $I_{RESETb}$ of Figure 4), preferably by rounding down the result of such division operation.

In case of set current pulses, the time-shift between the first set current pulses $PS_a$ provided to the first group of cells $100_a$ and the second set current pulses $PS_b$ provided to the second group of cells $100_b$ may be equal to a half of a set current pulse duration.

Therefore, the second set current pulses $PS_b$ provided to the second group of cells $100_b$ may start when the first set current pulses $PS_a$ provided to the first group of cells $100_a$ are in the middle.

In such a case, since the maximum number of cells that can be programmed in parallel during a set write operation $SETp_{MAX}$, that is, the maximum parallelism, is obtained by dividing the maximum pump current $I_{PUMP}$ for the maximum set current $I_{SETMAX}$, that is, via the equation $SETp_{MAX} = I_{PUMP}/I_{SETMAX}$, a first set current pulse of the first sequence of set current pulses $PS_a$ can be provided at the same time, being a first set current pulse among the set current pulses comprised in the first sequence of set current pulses $PS_a$ and in the second sequence of set current pulses $PS_b$, to a maximum number of cells equal to such maximum parallelism, that is, to the maximum number of cells that can be programmed in parallel during a set write operation $SETp_{MAX}$ obtained with the previous equation.

Therefore, while in the first set current pulse of the first sequence of set current pulses $PS_a$ the parallelism can be obtained via the equation $SETp_{MAX} = I_{PUMP}/I_{SETMAX}$, in the following set current pulses of such first sequence of set current pulses $PS_a$ or of the second sequence of set current pulses $PS_b$ the parallelism, that is, the number of cells that can be programmed in parallel, can be obtained via the following equation:

$$SETp_{NEXT} = SETp_{MAX} - SETp_{PREV}/2$$

wherein $SETp_{NEXT}$ is the parallelism of a following set current pulse that is to be provided as the next set current pulse and $SETp_{PREV}$ is the parallelism of the last set current pulse that has been provided.

It is noted that if the number $SETp_{PREV}/2$ is not an integer, a rounding up of such number is considered.

Therefore, in methods according to solutions as described herein, set current pulses $PS_a$ provided to the first set of cells, that is, to the cells that are to be written comprised in the first group of cells $100_a$, are time-shifted with respect to set current pulses $PS_b$ provided to the second set of cells, that is, to the cells that are to be written comprised in the second group of cells $100_b$, such time-shift being equal to a half of a set current pulse duration.

It is noted that a first set current pulse out of said set current pulses $PS_a$ provided to the first set of cells and said set current pulses $PS_b$ provided to the second set of cells (that is, a first set current pulse comprised in a sequence of set current pulses comprising the set current pulses provided to the first set of cells and those provided to the second set of cells) can be provided, at a first common write time (that is, in correspondence of a first time instant), to a number of cells targeting a maximum number of cells written in a respective set write operation performed via said first set current pulse at said first common write time, that is, via the set write operation performed by providing said first set current pulse to cells that are to be written in correspondence of such first time instant.

Such maximum number of cells written in the respective set write operation performed via the first set current pulse at said first common write time may be obtained by dividing the highest level of source current of the current pulse source, for instance, the maximum pump current $I_{PUMP}$ that can be provided by the program pump, by a highest current of the first set current pulse, for instance, the maximum set current $I_{SETMAX}$ provided at the beginning of such first set current pulse ($I_{SETMAXa}$ or $I_{SETMAXb}$ of Figure 4), preferably by rounding down the result of said division operation.

Similarly, a further set current pulse out of said set current pulses $PS_a$ provided to the first set of cells and said set current pulses $PS_b$ provided to the second set of cells (that is, a further set current pulse comprised in such sequence of set current pulses) can be provided, at a further common write time (that is, in correspondence of another time instant), to a number of cells targeting a maximum number of cells written in a respective set write operation performed via the further set current pulse at said further common write time, that is, via the set write operation performed by providing said further set current pulse to cells that are to be written in correspondence of such other time instant.

In such a case, such maximum number of cells written in the respective set write operation performed via the further set current pulse at such further common write time may be obtained:

by dividing the highest level of source current of the current pulse source, for instance, the maximum pump current $I_{PUMP}$ that can be provided by the program pump, by a highest current of the further set current pulse, for instance, the maximum set current $I_{SETMAX}$ provided at the beginning of the further set current pulse, obtaining a division result, preferably rounding down such division result, and

by subtracting to such division result a half, preferably rounded up, of a number of cells that have been pulsed in a set write operation that precedes such respective set write operation performed at such further common write time, that is, in a set write operation that precedes the set write operation performed by providing said further set current pulse to cells that are to be written in correspondence of such other time instant.

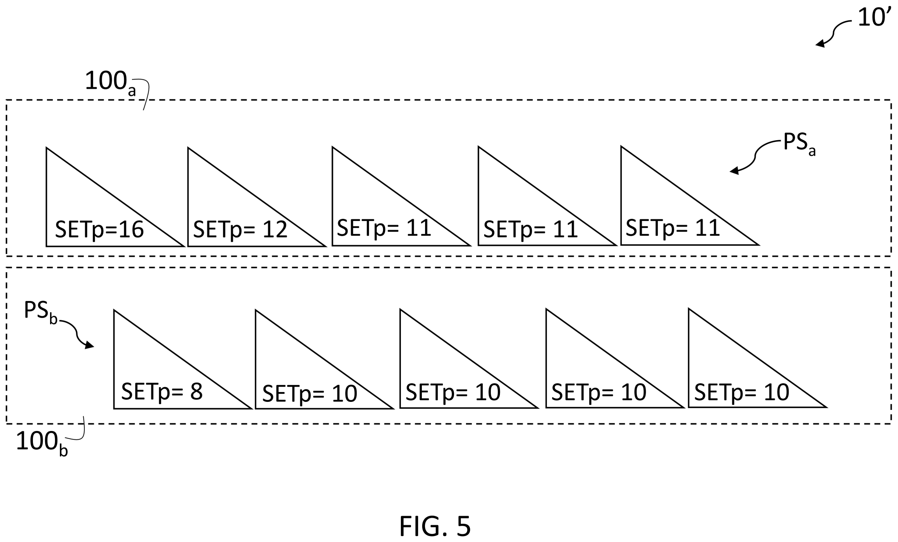

Figure 5 illustrates sequences 10' of set current pulses and a respective parallelism SETp, that is, a respective number of cells that can be written in parallel for each set current pulse, according to embodiments of the present description.

In the exemplary sequence 10' of Figure 5, the first set current pulse of the first sequence of set current pulses $PS_a$ is the first set current pulse among the set current pulses comprised in the first sequence of set current pulses $PS_a$ and in the second sequence of set current pulses $PS_b$, therefore, the parallelism of such first set current pulse of the first sequence of set current pulses $PS_a$ is equal to a maximum parallelism $SETp_{MAX}$, for instance, $SETp_{MAX}=16$ in the example of Figure 5.

Further set current pulses of either such first sequence of set current pulses $PS_a$ or such second sequence of set current pulses $PS_b$ have a parallelism that can be obtained via the previously described equation, that is, $SETp_{NEXT} = SETp_{MAX} - SETp_{PREV}/2$.

Therefore, a first set current pulse of the second sequence of set current pulses $PS_b$ is the second set current pulse among the set current pulses comprised in the first sequence of set current pulses $PS_a$ and in the second sequence of set current pulses $PS_b$, hence, by applying the previously described equation a parallelism of $SETp=8$ is obtained.

By applying the previously described equation to a time ordered sequence of current pulses comprised in the first sequence of set current pulses $PS_a$ and in the second sequence of set current pulses $PS_b$, and considering the rounding up for non-integer $SETp_{PREV}/2$ numbers, the parallelism illustrated in Figure 5 can be obtained.

In the exemplary scenario of Figure 5, a total of 109 cells is pulsed via the first sequence of set current pulses $PS_a$

and the second sequence of set current pulses $PS_b$ in a duration equal to 5.5 set current pulses duration.

It is noted that if the maximum parallelism $SETp_{MAX}$ is considered for a sequence of set current pulses as that illustrated in Figure 3A, the duration of pulsing 109 cells would be equal to 109/16=7 set current pulses duration, that is, about 27% more than the duration obtained by considering the pulse sequence of Figure 4 or 5.

Therefore, it can be seen how solutions as described herein may reduce the time required for programming the PCM, thus, accelerating such PCM program time.

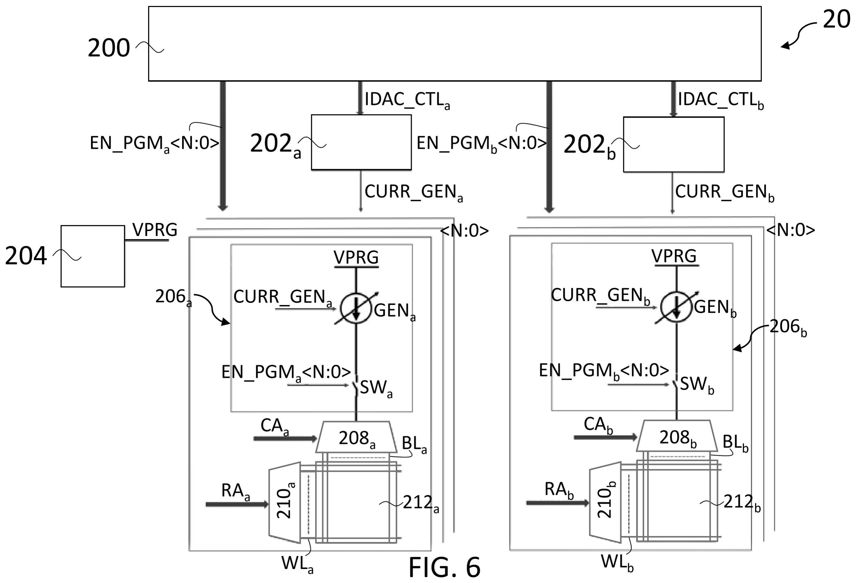

Figure 6 illustrates an exemplary structure 20 comprising control logic 200 according to embodiments of the present description driving two set of exemplary program divers $206_a$ and $206_b$, for instance, N+1 program drivers (referred to with the reference <N:0>), used in program operations of the PCM.

It is noted that the exemplary structure 20 of Figure 6 considers a plurality of groups comprising two groups of cells but structures related to more groups of cells may also be considered, for instance, by adding further set of program divers 206 and respective control signals.

It is noted that in the following description the references reported with subscript "a" refers to a structure related to a first group of cells $212_a$ of the two groups of cells, while the references reported with subscript "b" refers to a structure related to a second group of cells $212_b$ of such two groups. The references reported without subscript are related to a generic structure, that can be either the one related to the first group of cells $212_a$ or the one related to the second group of cells $212_b$.

The control logic 200 may be configured to generate, based on the maximum parallelism for set $SETp_{MAX}$ and reset $RESETp_{MAX}$ operations obtained as described above in order to maximize the usage of the program pump:

IDAC control buses IDAC_CTL for driving a plurality of IDAC ("Current Digital-to-Analog Converter") blocks 202, for instance, a first IDAC control bus IDAC_CTL$_a$ and a second IDAC control bus IDAC_CTL$_b$ for driving respective IDAC blocks $202_a$ and $202_b$; and

a plurality of switch control signals EN_PGM<N:0>, one for each set of program drivers 206, for instance, a first switch control signal EN_PGM$_a$<N:0> provided to a first set of program drivers $206_a$ and a second switch control signal EN_PGM$_b$<N:0> provided to a second set of program drivers $206_b$, used to select a subset of program drivers to be activated for each set of program drivers 206.

It is noted that each one of the switch control signals EN_PGM<N:0> comprises a plurality of components, for instance, N+1 components, EN_PGM<i> where i is a number ranging from 0 to N, each of such components being an indication of cells that are to be considered at the same time during the performing of program operations in the respective group of cells 212 via an i-th program driver comprised in the set of program drivers 206.

The exemplary structure 20 may comprise a plurality of IDACs, one IDAC for each group comprised in the plurality of groups of cells.

Since in the exemplary scenario considered in Figure 6 the plurality of groups comprises two groups of cells, such figure illustrates two IDACs, a first IDAC block $202_a$ and a second IDAC block $202_b$.

The first IDAC block $202_a$ and the second IDAC block $202_b$ are configured to convert a digital input value indicative of a current value, that is, the received first IDAC control bus IDAC_CTL$_a$ and second IDAC control bus IDAC_CTL$_b$ respectively, into an analog current CURR_GEN having such current value, that is, a first current CURR_GEN$_a$ and a second current CURR_GEN$_b$ respectively.

Such analog currents CURR_GEN, that is, the first current CURR_GEN$_a$ and the second current CURR_GEN$_b$, may be used as current references for the set of program drivers 206, that is, for the first set of program drivers $206_a$ and for the second set of program drivers $206_b$, respectively.

The exemplary structure 20 comprises also a program pump 204 configured to generate a program current used to perform program operations on cells of the PCM device, such program current being generated at a certain voltage VPRG.

Figure 6 illustrates the cells of the PCM divided into the plurality of groups 212, such plurality of groups 212 comprising a first group of cells $212_a$ and a second group of cells $212_b$. It is noted that, even if it is not illustrated in Figure 6, such first group of cells $212_a$ and such second group of cells $212_b$ may share a row decoding block 210.

Each group of cells 212, for instance, the first group of cells $212_a$ or the second group of cells $212_b$, in the plurality of groups of cells is arranged in word lines WL, for instance, first word lines WL$_a$ and second word lines WL$_b$ respectively, and bit lines BL, for instance, first bit lines BL$_a$ and second bit lines BL$_b$ respectively.

To select a given cell C, the word line WL, that is, either a word line in the first word lines WL$_a$ or in the second word lines WL$_b$, and the bit line BL, that is, either a bit line in the first bit lines BL$_a$ or in the second bit lines BL$_b$ respectively, coupled to the given cell C are to be selected.

The word lines WL, for instance, the first word lines WL$_a$ or the second word lines WL$_b$, can be selected via a word line demultiplexer 210, for instance, a first word line demultiplexer $210_a$ or a second word line demultiplexer $210_b$ respectively, based on a row address bus RA, for instance, a first row address bus RA$_a$ or a second row address bus

$RA_b$ respectively, indicative of the one or more cells in the respective group of cells 212 that are to be selected.

It is noted that, as previously described, the first word lines $WL_a$ and the second word lines $WL_b$ may share a same word line demultiplexer 210 driven by a same row address bus RA.

The bit lines BL, for instance, the first bit lines $BL_a$ or the second bit lines $BL_b$, can be selected via a bit line demultiplexer 208, for instance, a first bit line demultiplexer $208_a$ or a second bit line demultiplexer $208_b$ respectively, based on a column address bus CA, for instance, a first column address bus $CA_a$ or a second column address bus $CA_b$ respectively, indicative of the one or more cells in the respective group of cells 212 that are to be selected.

Such first group of cells $212_a$ and such second group of cells $212_b$ are coupled, via such first bit line demultiplexer $208_a$ and such second bit line demultiplexer $208_b$ respectively, to respective set of program drivers 206, that is, to the first set of program drivers $206_a$ and to the second set of program drivers $206_b$ respectively, that are configured to inject the generated program current (that is, set current pulses or reset current pulses) into the respective group of cells 212.

Each set of program drivers 206, for instance, the first set of program drivers $206_a$ or the second set of program drivers $206_b$, comprises a plurality of program drivers, for instance, N+1 program drivers, used in program operations.

Each program driver in a set of program drivers 206 may be configured to receive:

the respective analog current CURR_GEN generated by the respective IDAC block 202, for instance, the first current $CURR\_GEN_a$ if the program driver is comprised in the first set of program drivers $206_a$ or the second current $CURR\_GEN_b$ if the program driver is comprised in the second set of program drivers $206_b$. Such respective analog current CURR_GEN is a reference current for such program driver and contains information related to a program current that is to be injected in the cells coupled to such program driver that are to be programmed via respective program operations;

an i-th component (where i is a number ranging from 0 to N) of the respective switch control signal EN_PGM<N:0> generated by the control logic 200, for instance, an i-th component of the first switch control signal $EN\_PGM_a$<N:0> (thus, the component $EN\_PGM_a$<i>) if the program driver is comprised in the first set of program drivers $206_a$ or the second switch control signal $EN\_PGM_b$<N:0> (thus, the component $EN\_PGM_b$<i>) if the program driver is comprised in the second set of program drivers $206_b$. Such i-th component is indicative of cells that are to be considered at the same time during the performing, via such program driver comprised in the respective set of program drivers 206, of program operations in the respective group of cells 212; and

the program current at the certain voltage VPRG generated by the program pump 204.

Each program driver in the respective set of program drivers 206, for instance, the first set of program drivers $206_a$ or the second set of program drivers $206_b$, may be configured to mirror ("copy"), for instance, via a current mirror GEN such as a current mirror $GEN_a$ or a current mirror $GEN_b$ respectively, the received respective analog current CURR_GEN, for instance, the first current $CURR\_GEN_a$ or the second current $CURR\_GEN_b$ respectively, and to inject such mirrored analog current signal into the respective group of cells 212 that is to be programmed via respective program operations.

For instance, such current mirror GEN can be supplied with the certain voltage VPRG generated by the program pump 204 and, as previously described, can be configured to mirror the received respective analog current CURR_GEN.

It is noted that since each program driver in the set of program drivers 206 may comprise a current mirror GEN for mirroring such received respective analog current CURR_GEN, each of such program drivers share a same current pulse shape for each cell that is to be programmed at the same time, even if such cells that are to be programmed at the same time are coupled to different program drivers comprised in a same set of program drivers 206.

Therefore, the current mirror GEN can be configured to generate a program current that is to be injected into the cells of the respective group of cells, for instance, either the first group of cells $212_a$ or the second group of cells $212_b$, such program current being supplied to such cells, for instance, via the respective bit line demultiplexer 208, through a respective switch SW, for instance, a switch $SW_a$ or a switch $SW_b$ respectively.

Such respective switch SW may be coupled between the respective current mirror GEN and the respective bit line demultiplexer 208, such respective switch SW being configured to be controlled via the i-th component of the respective switch control signal EN_PGM<i>.

Therefore, the respective switch SW may be configured to:

open, that is, being in a non-conductive state, in response to such i-th component of the respective switch control signal EN_PGM<i> indicating to not consider cells coupled to the i-th program driver, that is, the program driver of the considered set of program drivers 206 that receives such i-th component, during the performing of a program operation; and

close, that is, being in a conductive state, in response to such i-th component of the respective switch control signal EN_PGM<i> indicating to consider at least one cell coupled to the i-th program driver in the considered set of program drivers 206 during the performing of the program operation.

To summarize, the method of solutions as described herein may comprise:

configuring the current pulse source, for instance, the program pump 204, of the PCM device to produce current pulses, that is, set PS or reset PR current pulses,

generating, for instance, via the control logic 200, a first switching bus, for instance, the first switch control signal $EN\_PGM_a<N:0>$, indicating whether to perform a write operation on cells comprised in the first group of cells, for instance, on cells comprised in the first group of cells $100_a$ or $212_a$,

generating, for instance, again via the control logic 200, a second switching bus, for instance, the second switch control signal $EN\_PGM_b<N:0>$, indicating whether to perform a write operation on cells comprised in the second group of cells, for instance, on cells comprised in the second group of cells $100_b$ or $212_b$,

arranging first pulse steering circuitry, for instance, the first set of program drivers $206_a$, the first bit line demultiplexer $208_a$, and the first word line demultiplexer $210_a$, between such current pulse source 204 of the PCM device and such first group of cells $100_a$ or $212_a$, such first pulse steering circuitry being configured to:

receive the first switching bus $EN\_PGM_a<N:0>$, and

direct current pulses produced by the current pulse source 204 of the PCM device towards such first group of cells $100_a$ or $212_a$ in response to such first switching bus $EN\_PGM_a<N:0>$ indicating to perform the write operation (a set write operation or a reset write operation) on cells comprised in such first group of cells $100_a$ or $212_a$; and

arranging second pulse steering circuitry, for instance, the second set of program drivers $206_b$, the second bit line demultiplexer $208_b$, and the second word line demultiplexer $210_b$, between such current pulse source 204 of the PCM device and such second group of cells $100_b$ or $212_b$, such second pulse steering circuitry being configured to:

receive the second switching bus $EN\_PGM_b<N:0>$, and

direct current pulses produced by the current pulse source 204 of the PCM device towards such second group of cells $100_b$ or $212_b$ in response to such second switching bus $EN\_PGM_b<N:0>$ indicating to perform the write operation (a set write operation or a reset write operation) on cells comprised in the second group of cells $100_b$ or $212_b$.

The exemplary structure 20 of Figure 6 may be generalized, as previously described, in order to consider more than two groups of cells, for instance, M>2 groups of cells, in the plurality of groups of cells.

It is noted that, even if M groups of cells are considered, such groups of cells may still share the row decoding block 210, that is, a same word line demultiplexer 210 driven by a same row address bus RA.

In solutions with M groups of cells, the exemplary structure 20 comprises M sets of program drivers 206 configured to inject the program current, that is, set current pulses and reset current pulses, in respective groups of cells of the M groups of cells.

Therefore, the exemplary structure 20 may also comprise M IDAC blocks 202 configured to convert respective received IDAC control buses IDAC_CTL, for instance, a first IDAC control bus $IDAC\_CTL_a$, a second IDAC control bus $IDAC\_CTL_b$, ..., and an M-th IDAC control bus $IDAC\_CTL_M$, into respective analog currents CURR_GEN, for instance, a first current $CURR\_GEN_a$, a second current $CURR\_GEN_b$, ..., and an M-th current $CURR\_GEN_M$ respectively, used as references for the respective program drivers.

The program pump 204 may, also in the case of M groups of cells, be configured to generate the program current used to perform program operations on cells of the PCM device, such program current being generated at the certain voltage VPRG.

In this case, the control logic 200 may be configure to generate, based on the maximum parallelism for set $SETp_{MAX}$ and reset $RESETp_{MAX}$ operations obtained as described above for the case that considers more than two groups of cells in the plurality of groups of cells and aiming at maximizing the usage of the program pump:

M IDAC control buses IDAC_CTL for driving the M IDAC blocks 202, for instance, the first IDAC control bus $IDAC\_CTL_a$, the second IDAC control bus $IDAC\_CTL_b$, ..., and the M-th IDAC control bus $IDAC\_CTL_M$; and

M switch control signals $EN\_PGM<N:0>$, for instance, a first switch control signal $EN\_PGM_a<N:0>$ provided to a first set of program drivers $206_a$, a second switch control signal $EN\_PGM_b<N:0>$ provided to a second set of program drivers $206_b$, ..., and an M-th switch control signal $EN\_PGM_M<N:0>$ provided to an M-th set of program drivers $206_M$, used to select a subset of program drivers to be activated for each set of program drivers 206.

Therefore, more in general, the method of solutions as described herein may comprise:

configuring the current pulse source, for instance, the program pump 204, of the PCM device to produce current pulses, that is, set PS or reset PR current pulses, and

for each group in the plurality of groups comprising a respective set of cells configured to be written via respective write operations (set or reset write operations):

generating, for instance, via the control logic 200, a switching bus, for instance, a switch control signal EN_PGM<N:0>, indicating whether to perform a write operation (set or reset write operation) on cells comprised in said group in the plurality of groups, and

arranging pulse steering circuitry, for instance, a set of program drivers 206, a bit line demultiplexer 208, and a word line demultiplexer 210, between such current pulse source 204 of the PCM device and such group in the plurality of groups, such pulse steering circuitry being configured to:

receive the switching bus EN_PGM<N:0>, and

direct current pulses produced by the current pulse source 204 of the PCM device towards such group in the plurality of groups in response to said switching bus EN_PGM<N:0> indicating to perform the write operation (the set write operation or the reset write operation) on cells comprised in such group in the plurality of groups.

Solutions as described herein facilitate obtaining a method of performing write operations, that is, program operations comprising set write operations and reset write operations, in a Phase Change Memory, PCM, device.

PCM devices according to solutions as described herein comprise:

a current pulse source, for instance, the program pump 204, that is, a current pump, configured to generate a highest level of source current, that is, the maximum pump current $I_{PUMP}$ being the maximum current that can be provided by the program pump, and to produce current pulses out of set current pulses PS and reset current pulses PR; and

a plurality of cells C arranged in a plurality of groups 100 or 212, wherein groups in said plurality of groups comprise respective sets of cells configured to be written via respective write operations.

The method according to the present description comprises performing the write operations, that is, the program operations:

via set current pulses PS for each set of cells comprising at least one cell to be written via a set write operation; and

via reset current pulses PR for each set of cells comprising at least one cell to be written via a reset write operation.

The set current pulses PS provided to cells comprised in one group of the plurality of groups are time-shifted with respect to set current pulses PS provided to cells comprised in the other groups of the plurality of groups, while reset current pulses PR provided to cells comprised in one group of the plurality of groups are dis-overlapped with respect to reset current pulses PR provided to cells comprised in the other groups of the plurality of groups.

It is noted that a sum of the set current pulses PS and the reset current pulses PR provided to cells comprised in the plurality of groups at a common write time is equal to or lower than the highest level of source current, that is, the maximum current that can be provided by the current pulse source $I_{PUMP}$, of the current pulse source, for instance, the program pump 204.

In addition, solutions as described herein also refers to a Phase Change Memory, PCM, device, the PCM device comprising:

such current pulse source, for instance the program pump 204, that is, a current pump, configured to generate a highest level of source current, for instance, the maximum current that can be provided by the program pump $I_{PUMP}$, and to produce current pulses out of set current pulses PS and reset current pulses PR; and

a plurality of cells C arranged in a plurality of groups 100 or 212, wherein groups in said plurality of groups comprise respective sets of cells configured to be written via respective write operations.

The PCM device according to solutions as described herein is configured to implement the method according to the present description.

Similarly, solutions as described herein also refers to a computer program product loadable in a control unit of a Phase Change Memory, PCM, device, the PCM device comprising:

such current pulse source configured to generate a highest level of source current and to produce current pulses out of set current pulses PS and reset current pulses PR; and

the plurality of cells C arranged in such plurality of groups, wherein groups in said plurality of groups comprise respective sets of cells configured to be written via respective write operations.

The computer program product according to solutions as described herein comprises portions of software code configured to cause the PCM device to implement the method according to the present description in response to the computer program product being run in the control unit of the PCM device.

Thus, solutions as described herein facilitate reducing a time required for programming the PCM, accelerating such PCM program time.

In fact, the PCM program time may be optimized by using in a more efficient way (described above) the program pump.

Without prejudice to the underlying principles, the details and the embodiments may vary, even significantly, with respect to what has been described by way of example only without departing from the scope of the embodiments.

The extent of protection is determined by the annexed claims.

**Claims**

1. A method of performing write operations in a Phase Change Memory, PCM, device, the PCM device comprising:

   a current pulse source (204), preferably a current pump, configured to generate a highest level of source current ($I_{PUMP}$) and to produce current pulses out of set current pulses and reset current pulses; and
   a plurality of cells (C) arranged in a plurality of groups (100; 212), wherein groups in said plurality of groups (100; 212) comprise respective sets of cells configured to be written via respective write operations,
   wherein:

   the method comprises performing said write operations via set current pulses (PS) for each set of cells comprising at least one cell to be written via a set write operation; and via reset current pulses (PR) for each set of cells comprising at least one cell to be written via a reset write operation;
   set current pulses (PS) provided to cells comprised in one group of the plurality of groups (100; 212) are time-shifted with respect to set current pulses (PS) provided to cells comprised in the other groups of the plurality of groups (100; 212), and reset current pulses (PR) provided to cells comprised in one group of the plurality of groups (100; 212) are dis-overlapped with respect to reset current pulses (PR) provided to cells comprised in the other groups of the plurality of groups (100; 212); and
   a sum of the set current pulses (PS) and the reset current pulses (PR) provided to cells comprised in the plurality of groups (100; 212) at a common write time is equal to or lower than said highest level of source current ($I_{PUMP}$) of the current pulse source (204).

2. The method according to claim 1, comprising performing said respective write operations targeting a maximum number of cells written via respective set or reset write operations at said common write time.

3. The method according to claim 1 or claim 2, comprising:

   configuring the current pulse source (204) of the PCM device to produce current pulses (PS, PR), and
   for each group in the plurality of groups (100; 212) comprising a respective set of cells configured to be written via respective write operations:

   generating (200) a switching bus ($EN\_PGM_a<N:0>$; $EN\_PGM_b<N:0>$) indicating whether to perform a write operation on cells comprised in said group in the plurality of groups (100; 212), and
   arranging pulse steering circuitry ($206_a$, $208_a$, $210_a$; $206_b$, $208_b$, $210_b$) between said current pulse source (204) of the PCM device and said group in the plurality of groups (100; 212), the pulse steering circuitry ($206_a$, $208_a$, $210_a$; $206_b$, $208_b$, $210_b$) being configured to:

   receive the switching bus ($EN\_PGM_a<N:0>$; $EN\_PGM_b<N:0>$), and
   direct current pulses produced by the current pulse source (204) of the PCM device towards said group in the plurality of groups (100; 212) in response to said switching bus ($EN\_PGM_a<N:0>$; $EN\_PGM_b<N:0>$) indicating to perform the write operation on cells comprised in said group in the plurality of groups (100; 212).

4. The method according to any one of the previous claims, wherein said plurality of cells (C) is arranged in two groups ($100_a$, $212_a$; $100_b$, $212_b$):

a first group of cells ($100_a$, $212_a$) comprising a first set of cells configured to be written via respective write operations, and

a second group of cells ($100_b$, $212_b$) comprising a second set of cells configured to be written via respective write operations.

**5.** The method according to claim 4, wherein reset current pulses ($PR_a$) provided to the first set of cells are dis-overlapped with respect to reset current pulses ($PR_b$) provided to the second set of cells;

said reset current pulses ($PR_a$) provided to the first set of cells being comprised in a first sequence of reset current pulses and said reset current pulses ($PR_b$) provided to the second set of cells being comprised in a second sequence of reset current pulses;
and wherein:

said reset current pulses ($PR_b$) comprised in said second sequence of reset current pulses are provided in correspondence of gaps of said first sequence of reset current pulses; and
said reset current pulses ($PR_a$) comprised in said first sequence of reset current pulses are provided in correspondence of gaps of said second sequence of reset current pulses.

**6.** The method according to claim 5, wherein:

a reset current pulse ($PR_a$) comprised in said first sequence of reset current pulses is provided, at a first common write time, to a number of cells of the first set of cells targeting a maximum number of cells written in a respective reset write operation performed via said reset current pulse ($PR_a$) at said first common write time; and
a reset current pulse ($PR_b$) comprised in said second sequence of reset current pulses is provided, at a second common write time, to a number of cells of the second set of cells targeting a maximum number of cells written in a respective reset write operation performed via said reset current pulse ($PR_b$) at said second common write time.

**7.** The method according to claim 6, wherein said maximum number of cells written in a respective reset write operation performed via a reset current pulse ($PR_a$, $PR_b$) at the first or second common write time is obtained by dividing the highest level of source current ($I_{PUMP}$) of the current pulse source (204) by a highest current ($I_{RESET}$) of the reset current pulse ($PR_a$, $PR_b$), preferably by rounding down the result of said division operation.

**8.** The method according to any one of claims 4 to 7, wherein set current pulses ($PS_a$) provided to the first set of cells are time-shifted with respect to set current pulses ($PS_b$) provided to the second set of cells;
said time-shift being equal to a half of a set current pulse duration.

**9.** The method according to claim 8, wherein:

a first set current pulse out of said set current pulses ($PS_a$) provided to the first set of cells and said set current pulses ($PS_b$) provided to the second set of cells is provided, at a first common write time, to a number of cells targeting a maximum number of cells written in a respective set write operation performed via said first set current pulse at said first common write time; and
a further set current pulse out of said set current pulses ($PS_a$) provided to the first set of cells and said set current pulses ($PS_b$) provided to the second set of cells is provided, at a further common write time, to a number of cells targeting a maximum number of cells written in a respective set write operation performed via said further set current pulse at said further common write time.

**10.** The method according to claim 9, wherein:

said maximum number of cells written in the respective set write operation performed via said first set current pulse at said first common write time is obtained by dividing the highest level of source current ($I_{PUMP}$) of the current pulse source (204) by a highest current ($I_{SETMAX}$) of the first set current pulse, preferably by rounding down the result of said division operation; and
said maximum number of cells written in the respective set write operation performed via said further set current pulse at said further common write time is obtained:

by dividing the highest level of source current ($I_{PUMP}$) of the current pulse source (204) by a highest current ($I_{SETMAX}$) of the further set current pulse, obtaining a division result, preferably rounding down said division result, and

by subtracting to said division result a half, preferably rounded up, of a number of cells that have been pulsed in a set write operation that precedes said respective set write operation performed at said further common write time.

11. The method according to any one of claims 4 to 10, comprising:

configuring the current pulse source (204) of the PCM device to produce current pulses (PS, PR),

generating (200) a first switching bus (EN_PGM$_a$<N:0>) indicating whether to perform a write operation on cells comprised in the first group of cells (100$_a$, 212$_a$),

generating (200) a second switching bus (EN_PGM$_b$<N:0>) indicating whether to perform a write operation on cells comprised in the second group of cells (100$_b$, 212$_b$),

arranging first pulse steering circuitry (206$_a$, 208$_a$, 210$_a$) between said current pulse source (204) of the PCM device and said first group of cells (100$_a$, 212$_a$), the first pulse steering circuitry (206$_a$, 208$_a$, 210$_a$) being configured to:

receive the first switching bus (EN_PGM$_a$<N:0>), and

direct current pulses produced by the current pulse source (204) of the PCM device towards said first group of cells (100$_a$, 212$_a$) in response to said first switching bus (EN_PGM$_a$<N:0>) indicating to perform the write operation on cells comprised in the first group of cells (100$_a$, 212$_a$); and

arranging second pulse steering circuitry (206$_b$, 208$_b$, 210$_b$) between said current pulse source (204) of the PCM device and said second group of cells (100$_b$, 212$_b$), the second pulse steering circuitry (206$_b$, 208$_b$, 210$_b$) being configured to:

receive the second switching bus (EN_PGM$_b$<N:0>), and

direct current pulses produced by the current pulse source (204) of the PCM device towards said second group of cells (100$_b$, 212$_b$) in response to said second switching bus (EN_PGM$_b$<N:0>) indicating to perform the write operation on cells comprised in the second group of cells (100$_b$, 212$_b$).

12. A Phase Change Memory, PCM, device, the PCM device comprising:

a current pulse source (204), preferably a current pump, configured to generate a highest level of source current (I$_{PUMP}$) and to produce current pulses out of set current pulses and reset current pulses; and

a plurality of cells (C) arranged in a plurality of groups (100; 212), wherein groups in said plurality of groups (100; 212) comprise respective sets of cells configured to be written via respective write operations;

said PCM device being configured to implement the method according to any one of the previous claims.

13. A computer program product loadable in a control unit of a Phase Change Memory, PCM, device, the PCM device comprising:

a current pulse source (204), preferably a current pump, configured to generate a highest level of source current (I$_{PUMP}$) and to produce current pulses out of set current pulses and reset current pulses; and

a plurality of cells (C) arranged in a plurality of groups (100; 212), wherein groups in said plurality of groups (100; 212) comprise respective sets of cells configured to be written via respective write operations;

the computer program product comprising portions of software code configured to cause the PCM device to implement the method according to any one of claims 1 to 11 in response to the computer program product being run in the control unit of the PCM device.

FIG. 1

EP 4 756 808 A1

FIG. 2B

FIG. 2A

FIG. 3A

FIG. 3B

FIG. 4

EP 4 756 808 A1

FIG. 5

FIG. 6

Europäisches
Patentamt
European
Patent Office
Office européen
des brevets

**EUROPEAN SEARCH REPORT**

Application Number

EP 25 21 7933

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2010/097850 A1 (CHO BEAK-HYUNG [KR] ET AL) 22 April 2010 (2010-04-22)<br>* paragraph [0069] - paragraph [0071]; figures 10-11 *<br>* paragraph [0063]; figure 7 *<br>----- | 1-13 | INV.<br>G11C13/00 |
| A | US 2007/133267 A1 (CHO BEAK-HYUNG [KR] ET AL) 14 June 2007 (2007-06-14)<br>* the whole document *<br>----- | 1-13 | |

TECHNICAL FIELDS
SEARCHED      (IPC)

G11C

The present search report has been drawn up for all claims

| Place of search | Date of completion of the search | Examiner |
|---|---|---|
| The Hague | 25 March 2026 | Lecoutre, Renaud |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 21 7933

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2026

| Patent document cited in search report | Publication date | Patent family member(s) | Publication date |
|---|---|---|---|
| US 2010097850 A1 | 22-04-2010 | CN 1734671 A | 15-02-2006 |
| | | EP 1617437 A1 | 18-01-2006 |
| | | JP 4832817 B2 | 07-12-2011 |
| | | JP 2006024355 A | 26-01-2006 |
| | | KR 20060004289 A | 12-01-2006 |
| | | TW 200603154 A | 16-01-2006 |
| | | US 2006007729 A1 | 12-01-2006 |
| | | US 2008137402 A1 | 12-06-2008 |
| | | US 2010097850 A1 | 22-04-2010 |
| | | US 2011242886 A1 | 06-10-2011 |
| US 2007133267 A1 | 14-06-2007 | CN 101004947 A | 25-07-2007 |
| | | JP 2007164964 A | 28-06-2007 |
| | | KR 20070060684 A | 13-06-2007 |
| | | US 2007133267 A1 | 14-06-2007 |
| | | US 2008025081 A1 | 31-01-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090161417 A1